# EUROPÄISCHE PATENTSCHRIFT

(11) **EP 1 146 560 B1**
(45) Veröffentlichungstag und Bekanntmachung des Hinweises auf die Patenterteilung: **06.12.2006**
(21) Anmeldenummer: 00107880.7
(22) Anmeldetag: 12.04.2000
(51) Int. Cl.: H01L 27/02

(54) **ESD-Latch-up-Schutzschaltung für eine integrierte Schaltung**
ESD Latch-up protection circuit for an integrated circuit
Circuit de protection Latch-up contre ESD pour circuits integrés

(43) Veröffentlichungstag der Anmeldung: 17.10.2001
(73) Patentinhaber: Infineon Technologies AG, 81669 München (DE)
(72) Erfinder: Uffmann, Dirk, 81825 München (DE); Peters, Christian, 81667 München (DE); Viehmann, Hans-Heinrich, 81739 München (DE)
(74) Vertreter: Epping - Hermann - Fischer

(56) Entgegenhaltungen:
- EP-A- 0 535 536
- EP-A- 0 703 622
- GB-A- 2 283 857
- US-A- 5 485 024
- US-A- 5 880 488
- US-A- 5 959 821

## Beschreibung

Die Erfindung betrifft eine ESD-Schutzschaltung für eine integrierte Schaltung, die in ein Halbleitersubstrat der integrierten Schaltung integriert ist, mit einer lateralen pnpn "Latch-up" Schutzstruktur, gebildet durch einen in einer ersten Dotierungsart dotierten ersten Bereich, der in einer entgegengesetzt, in einer zweiten Dotierungsart dotierten Wanne angeordnet und mit einer ersten Anschlußelektrode versehen ist, wobei die Wanne in das in der ersten Dotierungsart dotierte Halbleitersubstrat eingefügt ist, sowie durch einen in der zweiten Dotierungsart dotierten zweiten Bereich, der außerhalb der Wanne im Halbleitersubstrat angeordnet und mit einer zweiten Anschlußelektrode versehen ist, und mit einer hoch dotierten Zone der zweiten Dotierungsart, die auf der Wannengrenze, die Wanne dabei teilweise überlappend, entlang des zwischen den beiden Bereichen verlaufenden Abschnitts der Peripherie der Wanne angeordnet ist.

Eine derartige ESD-Schutzschaltung ist aus dem Fachbuch Ajith Amerasekera und Charvaka Duvvury, "ESD in Silicon Integrated Circuits", John Wiley and Sons, Chichester (1995), bekannt.

Integrierte Schaltungen, vor allem die empfindlichen Schaltungen in komplementärer MOS-Technik (CMOS), sollen häufig gegen Schäden, die durch eine elektrostatische Entladung (Electrostatic Discharge, ESD) verursacht werden können, geschützt werden. Ein ESD-Ereignis kann einen Spannungsdurchbruch durch ein zwei Oberflächen trennendes Dielektrikum hindurch, also letztlich einen Kurzschluß, zur Folge haben, der zu Schäden beispielsweise in Oxidschichten oder an Leiterbahnen bzw. Anschlüssen der integrierten Schaltung führen kann. Die dieser plötzlichen Entladung vorhergehende elektrostatische Aufladung der Schaltung kommt gewöhnlich durch Berührung der Schaltung durch einen elektrisch geladenen menschlichen Körper bzw. durch eine geladene Maschine zustande.

Zum Schutz vor derartigen ESD-Ereignissen werden üblicherweise Schutzschaltungen auf dem Halbleitersubstrat der zu schützenden Schaltung integriert, die sich bei Auftreten eines gefährlichen Entladestroms und/oder einer Entladespannung aktivieren, einen niederohmigen Zustand annehmen, und den Entladestrom mindestens insoweit ableiten, daß die empfindlichen Bereiche des zu schützenden Schaltkreises ungefährdet bleiben. Als wirksamster ESD-Schutz haben sich in den vergangenen Jahren Schaltungen mit lateralen pnpn "Latch-up" Strukturen erwiesen.

Der an sich seit längerem bekannte "Latch-up" Effekt wurde ursprünglich nur als unerwünschte Fehlerquelle bei CMOS-Schaltungen wahrgenommen. Diese weisen fast alle einen lateralen und einen vertikalen parasitären Bipolartransistor auf, die zusammen eine Vierschichtdiode pnpn, vergleichbar mit einem Thyristor, bilden. Bei Störungen der angelegten Versorgungsspannung kann die Vierschichtstruktur gezündet werden. Dieser Übergang vom Normalzustand der pnpn-Struktur in einen hochleitenden Zustand wird als "Latch-up" bezeichnet. Durch den, in diesem Zusammenhang ungewollt zwischen den Transistoranschlüssen gebildeten Strompfad kann die integrierte Schaltung thermisch überlastet werden.

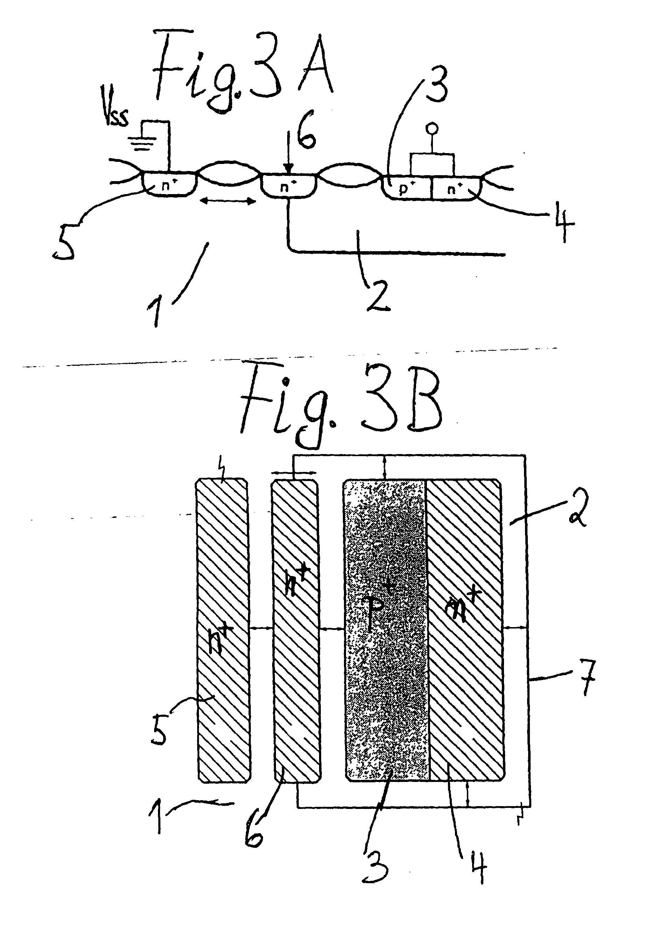

Eine ähnliche, jedoch gewollt und zusätzlich zur eigentlichen integrierten Schaltung erzeugte und auf lateral im Substrat angeordneten Elementen aufbauende Struktur wird derzeit, wie bereits erwähnt, als ESD-Schutz eingesetzt und ist in den Abschnitten 4.2.4 bis 4.3.1 des genannten Fachbuchs ausführlich beschrieben. Diese bekannte Latch-up-Schutzstruktur (Lateral Silicon Controlled Rectifier, LSCR) bzw. ihre auch dort beschriebene modifizierte Ausführung (MLSCR), wird nunmehr, zum besseren Verständnis der Erfindung, in Verbindung mit Figur 3 erläutert (vgl. die Figuren 4.35 und 4.31 aus Amerasekera et al).

Figur 3A zeigt eine schematische Querschnittsansicht einer bekannten MLSCR-ESD-Schutzstruktur. Wie in Figur 3A gezeigt, ist eine n-leitende Wanne 2 in ein schwach p-dotiertes Substrat 1 eingefügt. In der n-Wanne 2 ist ein hoch p-dotierter Bereich 3 , sowie, zum Anschluß der n-Wanne 2 an die Versorgungsspannung, ein hoch n-dotierter Bereich 4 erzeugt. Außerhalb der n-Wanne 2 ist ein weiterer hoch n-dotierter Bereich 5 erzeugt, der an Masse angeschlossen ist. Durch diese Anordnung ergibt sich bereits eine laterale pnpn-Struktur:
Bereich 3, n-Wanne 2, p-Substrat 1, Bereich 5,
welche die grundlegende LSCR-Schutzstruktur bildet. Maßgebend für die Zündspannung der pnpn-Schutzstruktur ist der pn-Übergang zwischen dem p-Substrat 1 und der n-Wanne 2 . Für heutige typische CMOS-Prozessparameter ergibt sich eine Zündspannung von etwa 50 V oder weniger.

Mit der immer stärkeren Miniaturisierung der Strukturen auf den Halbleiterchips und der damit einher gehenden Gefährdung schon durch kleinere Spannungen, werden ESD-Schutzschaltungen erforderlich, die bereits auf niedrige Spannungen, beispielsweise unter 50 V, reagieren. Um die Zündspannung zu verringern, wird in der genannten Literatur deshalb vorgeschlagen, zusätzlich die in Figur 3A dargestellte, hoch n-dotierte Zone 6 oberhalb der Wannengrenze n-Wanne 2 / p-Substrat 1 anzuordnen. Durch diese Maßnahme wird die Zündspannung dieser insofern modifizierten LSCR-Struktur (MLSCR) bei typischen 0,8*µ*m-CMOS-Prozessen nahezu halbiert und die parasitäre Kapazität erhöht. Die vorgeschlagene hoch dotierte n-Zone 6 ist als Streifen auf der Wannengrenze ausgeführt.

Figur 3B zeigt in einer schematischen Ansicht von oben das Layout der Schaltung gemäß Figur 3A. Gezeigt sind die innerhalb der n-Wanne 2 befindlichen Bereiche 3 und 4, sowie der seitlich außerhalb der n-Wanne 2 befindliche Bereich 5. Die streifenförmige hoch dotierte n-Zone 6 auf dem zwischen den Bereichen 3 und 5 verlaufenden Abschnitt der Peripherie 7 der n-Wanne 2 soll bewirken, daß die als Schutzstruktur verwendete laterale Latch-up-Struktur sowohl statisch als auch dynamisch bei einem ESD-Ereignis bei niedrigerer Spannung als bisher zündet und damit auch eher als andere, unbeabsichtigte parasitäre Latch-up-Strukturen innerhalb der integrierten Schaltung, um somit einen Ausfall der Schaltung durch Leiterbahnaufschmelzungen, erhöhte Leckströme usw. zu vermeiden.

Die angestrebte Erniedrigung der Zündspannung wird durch den Einsatz des MLSCR zwar erreicht, es ist jedoch aus der genannten Literatur auch bekannt und hat sich bei praktischen Tests bestätigt, daß mit der Erniedrigung der Zündspannung mit Hilfe der n-Zone 6 der Nachteil eines höheren On-Widerstandes der pnpn-Schutzstruktur nach dem Zünden einher geht. Dies hat beispielsweise für einen Chip, der mit dem LSCR Ausfälle ab 2kV (ESD-Test nach Human Body Modell) zeigte zur Folge, daß bei Einsatz des MLSCR bereits Ausfälle ab 1,5kV auftreten. Gemäß der genannten Literatur kommt der erhöhte On-Widerstand eben durch den zur Erniedrigung der Zündspannung eingesetzten n-Diffusionsstreifen 6 zustande, der direkt im niederohmigen (nach dem Zünden) Pfad der pnpn-Struktur liegt.

Ziel der vorliegenden Erfindung ist es, eine ESD-Schutzschaltung der eingangs genannten Art so zu gestalten, daß eine niedrige Zündspannung, jedoch ohne erhöhten On-Widerstand, resultiert.

Erfindungsgemäß wird dieses Ziel bei einer ESD-Schutzschaltung der eingangs genannten Art dadurch erreicht, daß die hoch dotierte Zone in Form von mit Zwischenabstand entlang des Abschnitts der Peripherie der Wanne angeordneten Flecken ausgebildet ist.

Durch die erfindungsgemäße ESD-Schutzschaltung mit ihrem optimierbaren Layout wird erreicht, daß die Zündspannung, wie beim bekannten MLSCR, sinkt und gleichzeitig ein niedriger On-Widerstand auftritt, der nahezu dem Wert beim LSCR entspricht. Dazu wird, anders als beim bekannten MLSCR, nicht eine durchgehende hoch dotierte Streifenzone über der Wannengrenze implantiert, sondern lediglich mehrere hoch dotierte Flecken mit Zwischenabständen. In Lückenbereichen zwischen den implantierten Flecken ist der Strompfad nach dem Zünden niederohmig wie beim LSCR, während die Funktion der Zündspannungserniedrigung durch die zwischen Anode und Kathode der pnpn- Struktur, entlang des pn-Übergangs n-Wanne /p-Substrat angeordneten hoch dotierten Flecken ausreichend erfüllt wird. Die beiden gewünschten Effekte werden also gleichzeitig in ein und demselben Abschnitt der Peripherie der Wanne erzielt. Dadurch eröffnen sich Möglichkeiten zur geschickten Gestaltung des Layouts, insbesondere im Hinblick auf eine Minimierung der von der ESD-Schutzschaltung innerhalb der integrierten Schaltung eingenommenen Fläche.

Es ist gemäß der vorliegenden Erfindung dabei unerheblich, ob die erste Dotierungsart eine p-Dotierung ist und die zweite Dotierungsart eine n-Dotierung ist, oder umgekehrt.

Eine vorteilhafte Ausgestaltung der ESD-Schutzschaltung mit besonders geschicktem Layout besteht darin, daß die Latch-up-Schutzstruktur aus zwei lateralen Bipolartransistoren spiegelsymmetrisch aufgebaut ist, die gebildet sind durch zwei lateral nebeneinander angeordnete, in der ersten Dotierungsart dotierte Bereiche, zwischen denen ein zentraler, in der zweiten Dotierungsart dotierter Bereich angeordnet ist, wobei alle drei Bereiche innerhalb der Wanne angeordnet und jeweils mittels einer Anschlußelektrode mit einem ersten Pol einer Versorgungsspannung verbunden sind, und durch zwei in der zweiten Dotierungsart dotierte Bereiche, die lateral, also jeweils neben den Bereichen, und außerhalb der Wanne im Halbleitersubstrat angeordnet sind, und daß die hoch dotierten Flecken entlang der beiden lateral spiegelsymmetrisch gegenüberliegenden Abschnitte der Peripherie der Wanne angeordnet sind.

Zweckmäßigerweise werden die Flecken entlang der genannten Abschnitte der Peripherie der Wanne mit regelmäßigen und mit für eine gleichmäßige Zündung der Latch-up-Schutzstruktur über die ganze Länge der genannten Abschnitte genügend kurzen Zwischenabständen angeordnet.

Die Erfindung wird nachfolgend an einem Ausführungsbeispiel anhand der Zeichnungen näher erläutert. Es zeigt
Figur 1 eine Ansicht von oben auf das Layout der erfindungsgemäßen Schutzschaltung,
Figur 2 eine Querschnittsansicht der erfindungsgemäßen Schutzschaltung gemäß Figur 1,
Figur 3A in gleicher Darstellung wie Figur 2 und Figur 3B in gleicher Darstellung wie Figur 1 eine aus dem Stand der Technik bekannte Schutzschaltung.

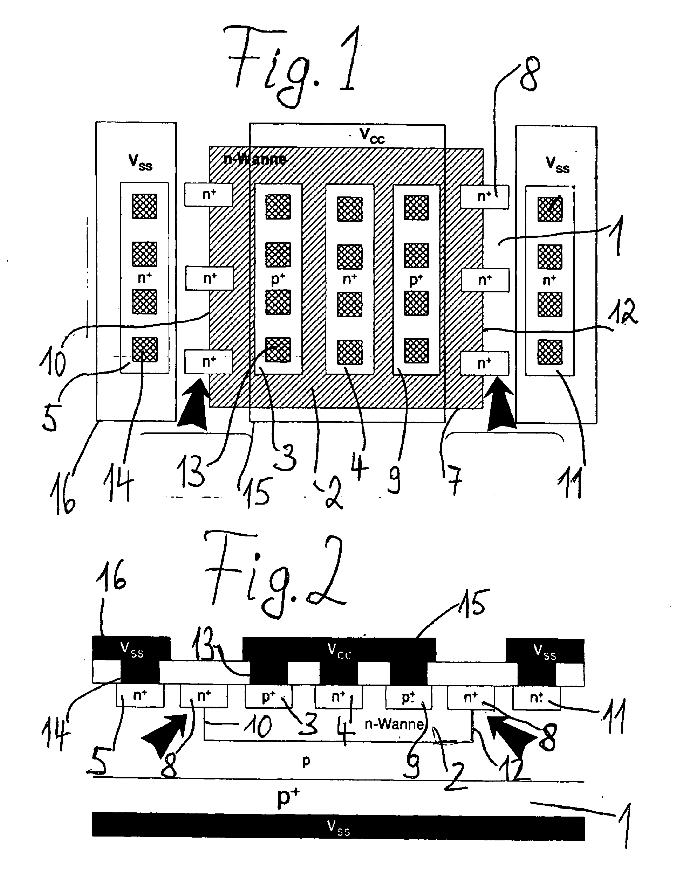

Figur 1 zeigt ein lateral spiegelsymmetrisches Layout. Im schwach p-dotierten Substrat 1 ist eine n-Wanne 2 eingefügt, in der ein zentraler streifenförmiger n-Bereich 4 und links und rechts davon jeweils ein hoch dotierter p-Bereich 3 und 9 erzeugt sind. Links und rechts außerhalb der n-Wanne 2 ist jeweils ein hoch dotierter n-Bereich 5 und 11 dargestellt. Beispielhalber dargestellt in Figur 1 sind auch die jeweils zu einer gemeinsamen oder einzelnen Metallisierung 15 und 16 führenden Anschlußelektroden 13 bzw. 14 der einzelnen Bereiche. Wie besser aus Figur 2 erkennbar, sind das üblicherweise über einen Rückseitenkontakt angeschlossene Halbleitersubstrat 1 und die einzelnen Bereiche 5, 3, 4, 9 und 11 mit der Masse Vₛₛ und der Versorgungsspannung V_{cc} verbunden. Nicht angeschlossen, sondern floatend sind die hoch n-dotierten Flekken 8. Die Wanne 2 ist über den zentralen, in der Mitte der lateralen Struktur angeordneten, hoch n-dotierten Bereich 4 angeschlossen. Die Wanne 2 kann mit den üblichen Mitteln der Prozesstechnologie (Implantation, Diffusion etc.) als Substratbereich des zweiten Leitfähigkeitstyps im dotierten Halbleitersubstrat 1 des ersten Leitfähigkeitstyps erzeugt werden. Die Dotierung der stark dotierten Bereiche bzw. Zonen der Schutzschaltung liegt je nach vorgegebener Prozesstechnik in einem Bereich von typischerweise 10²⁰/cm³.

Ein Abschnitt 10 der Peripherie 7 der n-Wanne 2 verläuft, wie in Figur 1 dargestellt, zwischen den Bereichen 5 und 3 und ein lateral spiegelsymmetrisch gegenüberliegender Abschnitt 12 verläuft zwischen den Bereichen 9 und 11. Die Abschnitte 10 und 12 bilden somit die linke bzw. rechte Schmalseite der rechteckförmigen Peripherie 7. Auf der Wannengrenze der Abschnitte 10 und 12 sind jeweils drei mit regelmäßigem Zwischenabstand plazierte hoch dotierte n-Flecken 8 angeordnet. Deren Größe kann vorteilhaft auf das vorgegebene, prozesstechnisch mögliche Minimum, beispielsweise 1x1 oder 2x2 *µ*m, begrenzt sein. Um das homogene Zünden der zwei nebeneinander liegenden pnpn-Strukturen über die gesamte Länge der jeweiligen Schmalseite zu gewährleisten, sollten die Flecken 8 nicht zu weit auseinander liegen. Bei einer Länge der Schmalseite von ca. 100*µ*m könnten deshalb etwa zehn regelmäßig beabstandete Flecken 8 erforderlich sein.

Im ESD-Fall führen Spannungsimpulse am Eingang/Ausgang der integrierten Schaltung zu einem dynamischen Zündvorgang in der Schutzschaltung, die daraufhin einen niederohmigen Zustand annimmt und dadurch den Entladestrom ableitet bzw. absorbiert. Der niederohmige Strompfad zwischen den hoch n-dotierten Flecken 8 verhindert das Bestehen einer zu hohen, eine potentielle Gefahr für die Schutzschaltung darstellenden Restspannung im gezündeten Zustand. Die rechteckförmige Peripherie 7 der Wanne 2 wird vorzugsweise nur, wie in Figur 1 dargestellt, an den Schmalseiten angeschlossen, damit ein Strompfad über Eck, der mit einer höheren Stromdichte und einer dementsprechend gefährlichen Verlustleistungsdichte einhergehen könnte, vermieden wird. Das in Figur 1 gezeigte lateral spiegelsymmetrische Layout führt gegenüber einer einseitigen Anordnung vorteilhafterweise zu einer verdoppelten Verlustleistung, die im ESD-Fall verkraftbar ist. Bei einseitiger Anordnung andererseits würde eine Verdopplung der Länge des Abschnitts 10 oder 12 notwendig mit einem unvertretbar hohen Flächenverbrauch der ESD-Schaltung innerhalb der integrierten Schaltung einhergehen.

Der allgemeine Vorteil der Erfindung besteht in einer Verbesserung des ESD-Schutzes von integrierten Schaltungen, z. B. Chipkarten-IC's, sowie der Vermeidung von Ausfällen bei Verwendung von Schaltungsmodulen mit ungünstigem Layout bzw. Latch-up. Für solche Module ist dann ein Re-use-Konzept weiterhin anwendbar. Bisher waren Redesign-Zyklen notwendig, um eine Qualifizierung gemäß ESD-Spezifikationen zu erreichen. Dies bedeutet ein Kosten-und Zeiteinsparungspotenzial.

### Bezugszeichenliste

- 1: Substrat
- 2: n-Wanne
- 3: p-Bereich
- 4: (zentraler) n-Bereich
- 5: n-Bereich
- 6: n-dotierte Zone
- 7: Peripherie der Wanne 2
- 8: n-dotierter Fleck
- 9: p-Bereich
- 10: Abschnitt der Peripherie 7
- 11: n-Bereich
- 12: Abschnitt der Peripherie 7
- 13: Anschlußelektroden
- 14: Anschlußelektroden
- 15: Metallisierung
- 16: Metallisierung
- 17:
- 18:
- 19:
- 20:

## Patentansprüche

1. ESD-Schutzschaltung für eine integrierte Schaltung, die in ein Halbleitersubstrat der integrierten Schaltung integriert ist,
mit einer lateralen pnpn "Latch-up" Schutzstruktur, gebildet durch einen in einer ersten Dotierungsart dotierten ersten Bereich (3), der in einer entgegengesetzt, in einer zweiten Dotierungsart dotierten Wanne (2) angeordnet und mit einer ersten Anschlußelektrode (13) versehen ist, wobei die Wanne (2) in das in der ersten Dotierungsart dotierte Halbleitersubstrat (1) eingefügt ist, sowie durch einen in der zweiten Dotierungsart dotierten zweiten Bereich (5), der außerhalb der Wanne (2) im Halbleitersubstrat (1) angeordnet und mit einen zweiten Anschlußelektrode (14) versehen ist,
und mit einer hoch dotierten Zone (6) der zweiten Dotierungsart, die auf der Wannengrenze, die Wanne (2) dabei teilweise überlappend, entlang des zwischen den beiden Bereichen (3,5) verlaufenden Abschnitts (10) der Peripherie (7) der Wanne (2) angeordnet ist,
**dadurch gekennzeichnet,**
**daß** die hoch dotierte Zone (6) in Form von mit Zwischenabstand entlang des Abschnitts (10) der Peripherie (7) der Wanne (2) angeordneten Flecken (8) ausgebildet ist.

2. ESD-Schutzschaltung nach Anspruch 1,
**dadurch gekennzeichnet,**
- **daß** die "Latch-up" Schutzstruktur aus zwei lateralen Bipolartransistoren spiegelsymmetrisch aufgebaut ist, die gebildet sind
durch zwei lateral nebeneinander angeordnete, in der ersten Dotierungsart dotierte Bereiche (3,9), zwischen denen ein zentraler, in der zweiten Dotierungsart dotierter Bereich (4) angeordnet ist, wobei alle drei Bereiche (3,9,4) innerhalb der Wanne (2) angeordnet und jeweils mittels einer Anschlußelektrode (13) mit einem ersten Pol einer Versorgungsspannung verbunden sind, und durch zwei in der zweiten Dotierungsart dotierte Bereiche (5,11), die lateral, also jeweils neben den Bereichen (3) und (9), und außerhalb der Wanne (2) im Halbleitersubstrat (1) angeordnet sind,
- und **daß** die hoch dotierten Flecken (8) entlang der beiden lateral spiegelsymmetrisch gegenüberliegenden Abschnitte (10, 12) der Peripherie (7) der Wanne (2) angeordnet sind.

3. ESD-Schutzschaltung nach Anspruch 1 oder 2,
**dadurch gekennzeichnet,**
**daß** die Flecken (8) entlang der genannten Abschnitte (10, 12) der Peripherie (7) der Wanne (2) mit regelmäßigen und mit für eine gleichmäßige Zündung der "Latch-up" Schutzstruktur über die ganze Länge der genannten Abschnitte (10, 12) genügend kurzen Zwischenabständen angeordnet sind.

4. ESD-Schutzschaltung nach einem der Ansprüche 1 bis 3,
**dadurch gekennzeichnet,**
**daß** die erste Dotierungsart eine p-Dotierung ist.

5. ESD-Schutzschaltung nach einem der Ansprüche 1 bis 3,
**dadurch gekennzeichnet,**
**daß** die erste Dotierungsart eine n-Dotierung ist.

6. Integrierte Schaltung mit einer ESD-Schutzschaltung nach einem der Ansprüche 1 bis 5,
**dadurch gekennzeichnet,**
**daß** die ESD-Schutzschaltung derart zwischen Eingangs/Ausgangs-Anschluß und Masseanschluß der integrierten Schaltung geschaltet ist, daß im Fall einer ausreichend starken elektrostatischen Entladung am Eingangs/Ausgangs-Anschluß die ESD-Schutzschaltung zündet, einen niederohmigen Zustand annimmt und dadurch den Entladestrom ableitet bzw. absorbiert.

## Claims

1. ESD protective circuit for an integrated circuit, which is integrated in a semiconductor substrate of the integrated circuit,
having a lateral pnpn "latch-up" protective structure formed by a first region (3), which is doped with a first doping type, is arranged in a well (2) doped oppositely, with a second doping type, and is provided with a first connection electrode (13), the well (2) being inserted into the semiconductor substrate (1) doped with the first doping type, and also by a second region (5), which is doped with the second doping type, is arranged outside the well (2) in the semiconductor substrate (1) and is provided with a second connection electrode (14),
and having a highly doped zone (6) of the second doping type, which is arranged on the well boundary, at the same time partly overlapping the well (2), along that section (10) of the periphery (7) of the well (2) which runs between the two regions (3, 5),
**characterized in that**
the highly doped zone (6) is designed in the form of pads (8) arranged with intermediate spacing along the section (10) of the periphery (7) of the well (2).

2. ESD protective circuit according to Claim 1,
**characterized**
- **in that** the "latch-up" protective structure is constructed mirror-symmetrically from two lateral bipolar transistors formed
by two regions (3, 9), which are arranged laterally next to one another and are doped with the first doping type and between which is arranged a central region (4) doped with the second doping type, all three regions (3, 9, 4) being arranged within the well (2) and each and by two regions (5, 11), which are doped with the second doping type and are arranged laterally, that is to say in each case next to the regions (3) and (9), and outside the well (2) in the semiconductor substrate (1),
- and **in that** the highly doped pads (8) are arranged along the two laterally mirror-symmetrically opposite sections (10, 12) of the periphery (7) of the well (2).

3. ESD protective circuit according to Claim 1 or 2,
**characterized**
**in that** the pads (8) are arranged along said sections (10, 12) of the periphery (7) of the well (2) with regular intermediate spacings which are short enough for uniform triggering of the "latch-up" protective structure over the entire length of said sections (10, 12).

4. ESD protective circuit according to one of Claims 1 to 3,
**characterized**
**in that** the first doping type is p-type doping.

5. ESD protective circuit according to one of Claims 1 to 3,
**characterized**
**in that** the first doping type is n-type doping.

6. Integrated circuit having an ESD protective circuit according to one of Claims 1 to 5,
**characterized**
**in that** the ESD protective circuit is connected between the input/output connection and ground connection of the integrated circuit in such a way that, in the event of a sufficiently intense electrostatic discharge at the input/output connection, the ESD protective circuit triggers, assumes a low-impedance state and thereby draws off or absorbs the discharge current.

## Revendications

1. Circuit de protection contre la décharge électrostatique pour un circuit intégré, placé dans un substrat semi-conducteur du circuit intégré,
- comportant une structure de protection contre le déclenchement parasite (« latch-up ») pnpn latérale formée par une première région (3), dopée d'après un premier type de dopage, qui est disposée dans un caisson (2) dopé d'après un deuxième type de dopage et qui est munie d'une première électrode de raccordement (13), le caisson (2) étant inséré dans le substrat semi-conducteur (1) dopé d'après le premier type de dopage, et par une deuxième région (5), dopée d'après le deuxième type de dopage, qui est disposée à l'extérieur du caisson (2) dans le substrat semi-conducteur (1) et qui est munie d'une deuxième électrode de raccordement (14),
- et comportant une zone (6) fortement dopée d'après le deuxième type de dopage et disposée sur la limite de caisson en dépassant en partie du caisson (2), le long de la portion (10) - située entre les deux zones (3, 5)
- de la périphérie (7) du caisson (2),
**caractérisé en ce que** la zone (6) fortement dopée prend la forme de points (8) placés à intervalles le long de la portion (10) de la périphérie (7) du caisson (2).

2. Circuit de protection contre la décharge électrostatique selon la revendication 1, **caractérisé en ce que**
- la structure de protection contre le déclenchement parasite comprend deux transistors bipolaires latéraux en symétrie de miroir formés
par deux régions (3, 9), placées latéralement l'une à côté de l'autre et dopées d'après le premier type de dopage, entre lesquelles se trouve une région (4) centrale dopée d'après le deuxième type de dopage, toutes les trois régions (3, 9, 4) étant à l'intérieur du caisson (2) et étant chacune reliées à un premier pôle d'une tension d'alimentation à l'aide d'une électrode de raccordement (13)
et par deux régions (5, 11) dopées d'après le deuxième type de dopage et situées de côté dans le substrat semi-conducteur (1), c'est-à-dire respectivement à côté des régions (3) et (9) et à l'extérieur du caisson (2),
- et que les points (8) fortement dopés se trouvent le long des deux portions (10, 12) - qui se font face latéralement en symétrie de miroir - de la périphérie (7) du caisson (2).

3. Circuit de protection contre la décharge électrostatique selon la revendication 1 ou 2, **caractérisé en ce que** les points (8) sont disposés le long desdites portions (10, 12) de la périphérie (7) du caisson (2) à des intervalles réguliers et assez courts pour amorcer régulièrement la structure contre le déclenchement parasite sur toute la longueur desdites portions (10, 12).

4. Circuit de protection contre la décharge électrostatique selon l'une des revendications 1 à 3, **caractérisé en ce que** le premier type de dopage est un dopage p.

5. Circuit de protection contre la décharge électrostatique selon l'une des revendications 1 à 3, **caractérisé en ce que** le premier type de dopage est un dopage n.

6. Circuit intégré comportant un circuit de protection contre la décharge électrostatique selon l'une des revendications 1 à 5, **caractérisé en ce que** le circuit de protection contre la décharge électrostatique est monté de telle manière entre une borne d'entrée ou de sortie et la borne de masse du circuit intégré que, au cas où la décharge électrostatique est suffisamment importante sur la borne d'entrée ou de sortie, le circuit de protection contre la décharge électrostatique est amorcé, prend un état de basse impédance et par conséquent détourne ou absorbe le courant de décharge.
